(19) Europäisches Patentamt / European Patent Office / Office européen des brevets

(11) **EP 1 801 599 B1**

(12) **EUROPÄISCHE PATENTSCHRIFT**

(45) Veröffentlichungstag und Bekanntmachung des Hinweises auf die Patenterteilung:
**18.06.2008 Patentblatt 2008/25**

(51) Int Cl.:
*G01R 27/26* (2006.01)   *G01L 9/12* (2006.01)
*H03M 1/00* (2006.01)

(21) Anmeldenummer: **06025922.3**

(22) Anmeldetag: **14.12.2006**

(54) **Messeinrichtung zur kapazitiven Druckmessung**

Measuring apparatus for capacitive pressure measurement

Dispositif de mesure destiné à la mesure capacitive de la pression

(84) Benannte Vertragsstaaten:
**DE FR**

(30) Priorität: **21.12.2005 DE 102005061090**

(43) Veröffentlichungstag der Anmeldung:
**27.06.2007 Patentblatt 2007/26**

(73) Patentinhaber: **ATMEL Germany GmbH
74072 Heilbronn (DE)**

(72) Erfinder:
• **Moser, Helmut
74078 Heilbronn (DE)**
• **Saile, Thomas
74670 Forchtenberg (DE)**

(56) Entgegenhaltungen:
**US-A- 3 761 805         US-A- 5 189 376**

• **RADEMAKER G ET AL: "A clock-shot A/D converter for integrated smart sensors" IEEE 1990 BIPOLAR CIRCUITS AND TECHNOLOGY MEETING, 17. September 1990 (1990-09-17), Seiten 206-209, XP010007981**
• **CICHOCKI A ET AL: "Switched-capacitor self-oscillating capacitance transducers with duty-cycle or digital output" EUROPEAN CONFERENCE ON CIRCUIT THEORY AND DESIGN, 1989, Seiten 185-189, XP006512211**
• **HIEROLD C ET AL: "A pure CMOS surface-micromachined integrated accelerometer" SENSORS AND ACTUATORS A, ELSEVIER SEQUOIA S.A., LAUSANNE, CH, Bd. 57, Nr. 2, November 1996 (1996-11), Seiten 111-116, XP004073447 ISSN: 0924-4247**

EP 1 801 599 B1

**Beschreibung**

Die Erfindung betrifft eine Messeinrichtung und ein Messverfahren zur kapazitiven Druck- und/oder Temperaturmessung, insbesondere für Reifendruckkontrollsysteme.

Wenngleich prinzipiell auf beliebige Druck- und Temperaturmesseinrichtungen anwendbar, werden die vorliegende Erfindung sowie die ihr zugrunde liegende Problematik nachfolgend mit Bezug auf drahtlose Druck- und Temperaturmesseinrichtungen unter Verwendung von Transpondern und hier insbesondere für Reifendruckkontrollsystemen erläutert. Zum allgemeinen Hintergrund der Transponder-Technologie wird auf das "RFID-Handbuch" von Klaus Finkenzeller, Hanser Verlag, dritte aktualisierte Auflage, 2002, verwiesen.

Transponder sind Mikroelektronikbauelemente, die dazu ausgelegt sind, Informationen speichern zu können. Transponder weisen hierfür eine Antennenanordnung auf, um ein kontaktloses Auslesen und eine Modifikation der gespeicherten Informationen zu ermöglichen. Bei Transpondern wird ein von einer Basisstation ausgesendetes elektromagnetisches Signal von dem Transponder aufgenommen und demoduliert.

Man unterscheidet aktive, semipassive und passive Transponder, je nach dem wie deren Energieversorgung ausgebildet ist. Im Gegensatz zu aktiven Transpondern weisen passive Transponder über keine eigene Energieversorgung auf, so dass der passive Transponder die für die Demodulation und Dekodierung des empfangenen elektromagnetischen Signals benötigte Energie aus dem elektromagnetischen Signal selbst entnehmen muss. Dies geschieht durch Absorptionsmodulation der gesendeten elektromagnetischen Wellen. Bei derzeit verwendeten passiven 110 - 140 kHz Transpondersystemen wird dies im elektromagnetischen Nahfeld durch eine induktive Kopplung realisiert. Die damit erzielte Energiereichweite liegt im Bereich von wenigen Zentimetern bis etwa einem halben Meter und hängt unter anderem von den jeweiligen nationalen HF-Vorschriften ab.

Passive Transponder werden im Bereich der kontaktlosen Kommunikation zur Identifikation (RFID = Radio Frequency Identification), bei Reifendruckkontrollsystem und dergleichen eingesetzt. Im Falle eines Reifendruckkontrollsystems werden zur Bestimmung reifenspezifischer Parameter, dabei insbesondere des Reifendrucks und der Reifentemperatur, typischerweise piezo-resistive oder kapazitive Drucksensoren eingesetzt, wobei die vorliegende Erfindung sich speziell auf kapazitiv ausgebildete Drucksensoren bezieht.

Mittels des kapazitiven Drucksensors soll der Absolutwert der Kapazität des Drucksensors bestimmt werden, der dem tatsächlichen Reifendruck des Autoreifens entspricht. Auf ähnliche Weise wird mit der internen Referenzkapazität die Reifentemperatur bestimmt. In diesem Falle wird die temperaturabhängige Ladung der Referenzkapazität ausgewertet. Zur Messung dieser Kapazität wird eine Spannung an dem Drucksensor angelegt. Die in der Kapazität des Drucksensors gespeicherte Ladung, die somit eine Information über den tatsächlichen Reifendruck enthält, wird anschließend in einem AD-Wandler unter Verwendung geeigneter Wandlerverfahren ermittelt. Die Herausforderung bei der Bestimmung des tatsächlichen Reifendrucks aus der durch diese Kapazität gespeicherte Ladung besteht nun in einer möglichst hohen Messgenauigkeit, wobei bei heutigen Reifendruckkontrollsystemen eine Auflösung von weniger als ein Promille gefordert wird.

Heute verwendete A/D-Wandler bzw. entsprechende Wandlerverfahren erreichen zwar unter Umständen eine solche hohe Genauigkeit bei der Auflösung, berücksichtigen aber nicht die Integrationsfähigkeit des Drucksensors. Insbesondere muss der kapazitive Drucksensor zur Reifendruckmessung als Bestandteil einer integrierten Schaltung, die an einem Rad eines Kraftfahrzeuges angeordnet ist oder in dessen Gummimaterial einvulkanisiert ist, möglichst klein und somit flächenoptimiert ausgebildet sein. Heute verwendete A/D-Wandler und kapazitive Drucksensoren, die für eine hohe Genauigkeit ausgelegt sind, sind hier nicht oder nur bedingt dazu ausgelegt geeignet. Darüber hinaus weisen diese eine relativ lange Wandlerzeit zur Ermittlung der Kapazität des kapazitiven Drucksensors und somit des tatsächlichen Reifendrucks auf. Eine lange Wandlerzeit geht aber unmittelbar einher mit einer hohen Energieaufnahme, die es allerdings insbesondere bei Reifendruckkontrollsystemen, bei denen der Transponder die Energie aus dem elektromagnetisch übermittelten Signal entnehmen muss, zu vermeiden gilt.

In dem Artikel von Werner Schulz, "Integrierter Drucksensor wird drahtlos versorgt" in der Zeitschrift Elektronik, 7/2000, Seite 54 ist ein Druck- und Temperatursensor mit drahtloser Übermittlung von Messdaten für mikroelektronische Schaltungen beschrieben. Die Stromversorgung kann hier in Folge der geringen Leistungsaufnahme aus dem Feld einer bis zu einem Meter entfernten Basisstation entnommen werden.

In dem Fachbuch von Tietze, Schenk "Halbleiterschaltungstechnik", 11. Auflage, Seite 1059-1060 ist ferner ein allgemein bekanntes so genanntes Zweirampenverfahren (Dual Slope) beschrieben, mittels dem die Kapazität eines Kondensators ermittelt werden kann.

US-A-3 761 805 offenbart die Messung einer Kapazitanz durch Konstantstromladungstechnik.

Vor diesem Hintergrund liegt der vorliegenden Erfindung die Aufgabe zugrunde, ein möglichst einfaches Verfahren zur Kapazitätsmessung für einen kapazitiven Drucksensor bereitzustellen, der insbesondere eine möglichst hohe Auflösung bereitstellt. Eine alternative Aufgabe besteht darin, ein entsprechendes Verfahren zur Kapazitätsmessung mit einer möglichst geringen Energieaufnahme bereitzustellen.

Erfindungsgemäß wird zumindest eine der obigen Aufgaben durch eine Messeinrichtung mit den Merkmalen des Patentanspruchs 1 und durch ein Messverfahren mit den Merkmalen des Patentanspruchs 14 gelöst.

Die der vorliegenden Erfindung zugrunde liegende Idee besteht darin, ein Zweirampenmessverfahren, nachfolgend auch als Dual-Slope-Messverfahren bezeichnet, für die Messung der Kapazität eines kapazitiven Drucksensors zu verwenden. Der besondere Vorteil eines solchen Zweirampenmessverfahrens im Vergleich zu anderen Messverfahren besteht in dessen hoher Messgenauigkeit. Um nun diese Messgenauigkeit noch weiter zu verbessern, wird bei dem erfindungsgemäßen Verfahren die Messung der Ladung in der Kapazität des kapazitiven Drucksensors und somit zur Ermittlung der Kapazität mehrfach wiederholt, um dadurch das unkorrelierte Rauschen der Referenzschwellen, welches üblicherweise dem Zweirampenmessverfahren inhärent ist, herauszumitteln. Dieses Rauschen ergibt sich dadurch, dass eine jeweilige ansteigende bzw. abfallende Rampe des Messsignals nicht genau bei den Referenzschwellen, wie dies idealerweise der Fall ist, umgeschaltet wird, sondern geringfügig über die jeweilige Referenzschwelle nachläuft. Der besondere Vorteil bei der erfindungsgemäßen Messeinrichtung bzw. bei dem entsprechenden Messverfahren besteht also in der sehr hohen Messgenauigkeit aufgrund des mehrfachen Durchführens des Zweirampenmessverfahrens. Auf diese Weise wird eine einzelne, unerwünschte Aufladung theoretisch auf mehrere Messzyklen aufgeteilt, wodurch Messungenauigkeiten herausmittelt werden.

Der Vorteil besteht hier insbesondere auch darin, dass durch dieses Messverfahren eine geringere Versorgungsspannung einsetzbar ist, da für die vergleichsweise geringen Rampen im Falle des verwendeten Taktsignals gegenüber dem Messsignal eine signifikant geringere Versorgungsspannung benötigt wird.

Um ferner den Fehler beim Umschalten an den Referenzschwellen weiter zu korrigieren, können vor der eigentlichen Messung vorzugsweise zwei Korrekturmessungen durchgeführt werden. Bei diesen Korrekturmessungen wird zunächst ein einfacher Kapazitätswert und anschließend ein dazu doppelter Kapazitätswert gemessen. Der Unterschied zwischen diesen beiden Korrekturmessungen gibt die Laufzeit wieder, welche anschließend bei der Berechnung des tatsächlichen Kapazitätswertes des kapazitiven Drucksensors berücksichtigt werden muss. Die Kapazitätswerte des einfachen Kapazitätswerts und des doppelten Kapazitätswerts sind sehr genau bekannt und können somit als Referenz für die eigentliche Kapazitätsmessung verwendet werden. Auf diese Weise kann ein in mehrere Zyklen unterteiltes Zweirampenverfahren korrigiert und auch beliebig erweitert werden, ohne dass sich Umschaltfehler aufsummieren können.

Vorteilhafte Ausgestaltungen und Weiterbildungen der Erfindung ergeben sich aus den weiteren Unteransprüchen sowie aus der Beschreibung in Zusammenschau mit der Zeichnung.

In einer bevorzugten Ausgestaltung ist ein Oszillator vorgesehen, der ausgangsseitig ein Oszillatortaktsignal erzeugt, dessen Frequenz zumindest höher ist als die Frequenz des Messpotenzials.

In einer ebenfalls bevorzugten Ausgestaltung gibt der Periodenzähler ausgangsseitig ein erstes Zählerstandssignal als Maß für die gezählten Perioden des Messpotenzials aus. Der Taktzähler gibt ausgangsseitig ein zweites Zählerstandssignal als Maß für die gezählten Takte des Taktsignals aus. Typischerweise, jedoch nicht notwendigerweise ist/sind der Periodenzähler und/oder der Taktzähler als Aufwärtszähler oder als Abwärtszähler ausgebildet ist/sind. Diese inkrementieren bzw. dekrementieren die ihren Zählerstand mit jeder Periode des Messpotenzials bzw. mit jedem Takt des Taktsignals um plus eins.

In einer bevorzugten Weiterbildung weist die Lade-/Entladeschaltung zur Erzeugung des sägezahnartigen Messpotenzials zumindest eine schaltbare Stromquelle auf. Hierzu kann die Lade-/Entladeschaltung jeweils zumindest eine erste Stromquelle zum Aufladen eines jeweils zu messenden kapazitiven Elements und jeweils zumindest eine zweite Stromquelle zum Entladen des jeweils zu messenden kapazitiven Elements aufweisen. Zum wechselseitigen Aufladen und Entladen ist zumindest ein steuerbarer Schalter zwischen jeder Stromquelle und dem Messknoten angeordnet. Typischerweise sind die steuerbarer Schalter durch ein vom Messpotenzial abgeleitetes Steuersignal derart angesteuert, dass dadurch entweder die erste oder die zweite Stromquelle aktiviert ist.

In einer bevorzugten Ausgestaltung weist die Lade-/Entladeschaltung zur Erzeugung des sägezahnartigen Verlaufs des Messpotenzials eine Schwellwertschaltung auf, welche dem Messknoten nachgeschaltet ist, die das Messpotenzial mit einem vorgegebenen oberen und unteren Schwellenwert vergleicht und die bei Überschreiten des Messpotenzials über den oberen Schwellenwert bzw. bei Unterschreiten des Messpotenzials unter den unteren Schwellenwert das Steuersignal zur Ansteuerung der steuerbaren Schaltern derart ändert, dass der Lade-/Entladevorgang des zu messenden Elements dadurch umgekehrt ist.

In einer typischen und auch bevorzugten Ausgestaltung weist der Sensor eine Kapazitätsanordnung auf, die neben dem Messelement zur Erfassung der Zustandsgröße zumindest ein kapazitives Referenzelement als Referenz für das Messelement enthält.

In einer bevorzugten Ausgestaltung weist die Kapazitätsanordnung ferner zumindest zwei Korrekturkapazitäten auf, welche für ein Herausmitteln eines unkorrelierten Rauschens, welches durch ein Über- oder Unterschreiten des Messpotenzials über eine obere Referenzschwelle bzw. unter eine untere Referenzschwelle entsteht, vorgesehen sind. Typischerweise weist eine erste Korrekturkapazität gegenüber der zweiten Korrekturkapazität einen doppelten Kapazitätswert auf.

Typischerweise, jedoch nicht notwendigerweise, ist die Zustandsgröße ein Reifen spezifischer Parameter, insbesondere der Reifendruck oder die Reifentemperatur. Der Sensor ist hierzu als kapazitiver Drucksensor zum Erfassen eines Drucks ausgebildet.

Die Erfindung wird nachfolgend anhand der in den schematischen Figuren der Zeichnung angegebenen Ausführungsbeispiele näher erläutert. Es zeigen dabei:

Fig. 1 ein Blockschaltbild einer erfindungsgemäßen Messeinrichtung zum Erfassen eines Kapazitätswertes eines kapazitiven Drucksensors;

Fig. 1A ein Signal-Zeit-Verlauf des Messpotenzials zur Darstellung des erfindungsgemäßen Messverfahrens der Messeinrichtung aus Fig. 1;

Fig. 2 ein Signal-Zeit-Diagramm einer einzelnen Periode des Messsignals zur Darstellung des erfindungsgemäßen Messverfahrens;

Fig. 3 ein Signal-Zeit-Diagramm zweier Takte des Taktsignals zur Darstellung des erfindungsgemäßen Messverfahrens;

Fig. 4 ein Signal-Zeit-Diagramm zweier Takte des Taktsignals zur Darstellung des erfindungsgemäßen Messverfahrens.

In den Figuren der Zeichnung sind gleiche und funktionsgleiche Elemente, Merkmale und Signale - sofern nichts Anderes angegeben ist - mit denselben Bezugszeichen versehen worden.

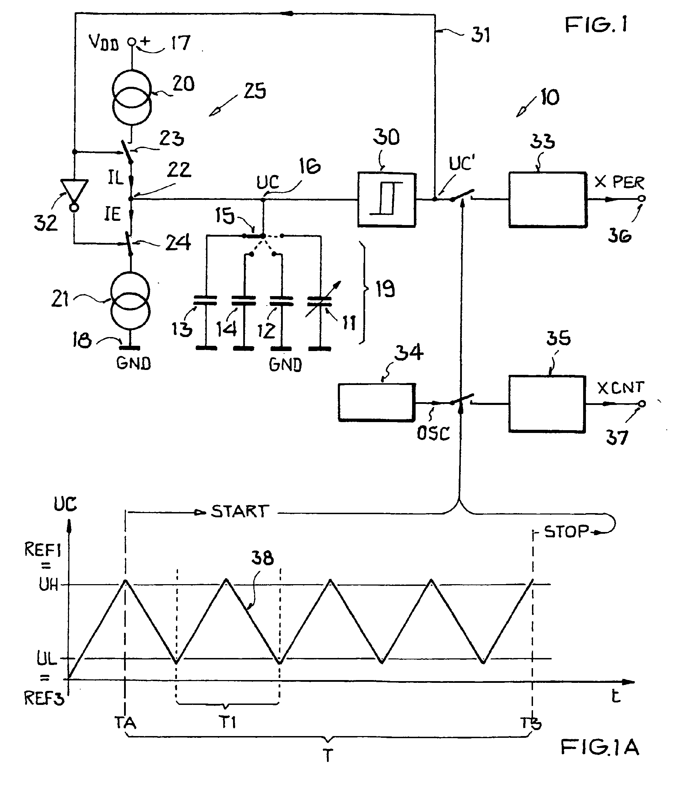

Fig. 1 zeigt ein Blockschaltbild einer erfindungsgemäßen Messeinrichtung zum Erfassen eines Kapazitätswertes eines kapazitiven Drucksensors. Die erfindungsgemäße Messeinrichtung dient der Ermittlung reifenspezifischer Parameter mittels eines kapazitiven Drucksensors. Unter reifenspezifischen Parameter sind z. B. der aktuelle Reifendruck oder die aktuelle Reifentemperatur zu verstehen.

Die erfindungsgemäße Messeinrichtung ist in Fig. 1 mit Bezugszeichen 10 bezeichnet. Die Messeinrichtung 10 enthält eine Kapazitätsanordnung 19 mit einem kapazitiven Drucksensor 11, dessen Kapazität CP abhängig von dem zu messenden Reifendruck im Bereich von typischerweise CP= 5 - 20 pF schwanken kann. Mittels der erfindungsgemäßen Messeinrichtung 10 wird diese Kapazität CP als Maß für den Reifendruck erfasst. Hierzu weist die Kapazitätsanordnung 19 ferner eine Referenzkapazität 12 sowie zwei Korrekturkapazitäten 13, 14 auf. Die Referenzkapazität 12, die als Referenz für die Messung herangezogen werden soll, weist einen Referenzkapazitätswert von zum Beispiel CREF = 8 pF auf. Mit dem gleichen Messverfahren wird mit CREF = 8 pF die Reifentemperatur ermittelt. Hierzu sind wie bei der Reifendruckermittlung auch zwei Messungen erforderlich. Hierbei wird die Ladung auf CREF mit einer temperaturabhängigen und temperaturunabhängigen Größe verglichen.

Die beiden Korrekturkapazitäten 13, 14 dienen dem Zweck, einen Messfehler und damit einhergehende Messungenauigkeiten beim Umschalten an den jeweiligen Referenzschwellen zu korrigieren. Die erste Korrekturkapazität 13 weist einen Kapazitätswert von z. B. CORO = 1 pF auf. Die zweite Korrekturkapazität 14 weist einen gegenüber der ersten Korrekturkapazität 13 verdoppelten Kapazitätswert auf, also im gezeigten Beispiel von COR1 = 2 pF.

Die erfindungsgemäße Messeinrichtung 10 weist zwei Versorgungsanschlüsse 17, 18 auf. Der erste Versorgungsanschluss 17 weist ein erstes Versorgungspotenzial VDD, beispielsweise ein positives Gleichspannungspotenzial VDD, auf, wohingegen der zweite Versorgungsanschluss 18 mit einem zweiten Versorgungspotenzial GND, beispielsweise ein Bezugspotenzial GND, beaufschlagt ist.

Die Kapazitäten 11 - 14 der Kapazitätsanordnung 19 sind jeweils einerseits mit dem zweiten Versorgungsanschluss 18 verbunden. Ferner ist ein steuerbarer Schalter 15 vorgesehen, über welche zumindest eine dieser Kapazitäten 11 - 14 auf den Messknoten 16 aufschaltbar ist. An diesem Messknoten 16 liegt somit ein Messpotenzial UC an, welches somit der in der jeweils aufgeschalteten Kapazitäten 11 - 14 gespeicherten Ladung entspricht.

Für das erfindungsgemäße Messverfahren unter Verwendung eines Zweirampenmessverfahrens müssen diese Kapazitäten 11 - 14 der Kapazitätsanordnung 19 wechselseitig aufgeladen und wieder entladen werden. Hierzu ist eine Stromquellenanordnung 25 vorgesehen. Die Stromquellenanordnung 25 weist zwei Stromquellen 20, 21 auf. Die erste Stromquelle 20 dient dem Aufladen der jeweils aufgeschalteten Kapazität 11-14 und ist hierzu zwischen dem ersten Versorgungsanschluss 17 und einem Abgriff 22, der den Ausgang der Stromquellen 20, 21 bildet, angeordnet. Der Abgriff 22 ist mit dem Messknoten 16 verbunden. Zum Aufladen einer jeweiligen Kapazität 11 - 14 ist ferner ein steuerbarer Schalter 23 vorgesehen, über den bei geschlossenem Schalter 23 die Stromquelle 20 einen Ladestrom IL zum Aufladen einer jeweiligen Kapazität 11 - 14 erzeugt. Die zweite Stromquelle 21, welche mit dem zweiten Versorgungsanschluss 18 verbunden ist, dient dem Entladen einer jeweiligen Kapazität 11 - 14 mit einem Entladestrom IE, sofern ein zwischen der zweiten Stromquelle 21 und dem Abgriff 22 angeordneter gesteuerter Schalter 24 geschlossen ist.

Die steuerbaren Schalter 23, 24 können z. B. als einfache MOSFET-Transistoren (CMOS-Technologie) oder als Bipolartransistoren (Bipolartechnologie) ausgebildet sein.

Die erfindungsgemäße Messeinrichtung 10 enthält ferner eine Schwellwertschaltung 30, die einen intern vorgegebenen oberen und einen unteren Schwellenwert UH, UL für das Messpotenzials UC vorgibt. Die Schwellwertschaltung 30 nimmt das Messpotenzial UC auf und vergleicht dieses Messpotenzial UC mit dem oberen und unteren Schwellenwert UH, UL. Das am Ausgang der Schwellwertschaltung 30 bereitgestellte Messpotenzial UC' wird über einen Rückkopplungspfad 31 zur Ansteuerung der beiden steuerbaren Schalter 23, 24 verwendet, wobei dieses Signal UC' zur direkten Ansteuerung des steuerbaren Schalters 23 und über einen Inverter 32 zur Ansteuerung des steuerbaren Schalters 24 verwendet wird.

Zunächst wird bei geschlossenem Schalter 23 eine jeweils zu messende Kapazität 11 - 14 der Kapazitätsanordnung 19 mit dem Ladestrom IL aufgeladen. Die entsprechende, langsam ansteigende Ladung der Kapazität 11 - 14 führt zu einem Ansteigen des Messpotenzials UC, welches in der Schwellwertschaltung 30 mit dem oberen Schwellenwert UH verglichen wird. Übersteigt das gemessene Messpotenzial UC den oberen Schwellenwert UH, dann führt dies zu einer Signalumkehr im Ausgangssignal UC', was unmittelbar dazu führt, dass der Schalter 23 geöffnet und der Schalter 24, der anfänglich geöffnet war, geschlossen wird. Auf diese Weise wird die entsprechende Kapazität 11 - 14 der Kapazitätsanordnung 19 mit dem Entladestrom IL entladen. Die entsprechende, langsam abfallende Ladung und damit das abfallende Messpotenzial UC wird in der Schwellwertschaltung 30 mit dem unteren Schwellenwert UL verglichen. Fällt das gemessene Messpotenzial UC unter den unteren Schwellenwert UL, dann führt dies wieder zu einer Signalumkehr im Ausgangssignal UC', was unmittelbar dazu führt, dass der Schalter 24 wieder geöffnet und der Schalter 23 geschlossen wird. Das Messpotenzial UC beschreibt somit einen sägezahnartigen Messverlauf, wie er in der Fig. 1A dargestellt ist.

Ferner ist ein Periodenzähler 33 vorgesehen, der die einzelnen Perioden 38 des sägezahnartigen Signals UC ermittelt. Am Ausgang 36 des Periodenzählers 33 ist somit ein Zählerstandsignal XPER abgreifbar. Das Zählerstandsignal XPER gibt an, wie viele vollständige Perioden 38 des Signals UC gezählt wurden. Im Beispiel in der Fig. 1A sind insgesamt viereinhalb Perioden 38 des Messsignals UC während der Zeitdauer T = TB - TA gezeigt.

Ferner ist ein Oszillator 34 vorgesehen, der ausgangsseitig ein Oszillatortaktsignal OSC bereitstellt. Die einzelnen Takte 39 des Taktsignals OSC werden ebenfalls in einem eigens dafür vorgesehenen Messzähler 35 gezählt. Am Ausgang 37 des Messzählers 35 ist also ein Zählerstandsignal XCNT abgreifbar, welches angibt, wie viele Takte 39 des Taktsignals OSC innerhalb einer vorgegebenen Zeitdauer gezählt wurden.

Fig. 1A zeigt anhand eines Signal-Zeit-Diagramms den Verlauf des Messpotenzials UC. Mit Bezugszeichen 38 ist hier eine einzelne Periode der Dauer T1 des Messpotenzials UC angegeben. Der Periodenzähler 33 ist dazu ausgelegt, alle Perioden 38 des Messpotenzials UC innerhalb der Messdauer T zu bestimmen. Diese Messdauer T ergibt sich aus der Zeit zwischen dem Start der Messung zum Zeitpunkt TA und bis zum Stopp der Messung zum Zeitpunkt TB. Die Startzeit TA wird typischerweise so gewählt, dass sie zu einem fest vorgegebenen Zeitpunkt bezogen auf das Messpotenzial UC, beispielsweise zu dessen Maximum (oder alternativ auch zu dessen Minimum), gewählt ist. Die Stoppbedingung TB hängt jeweils davon ab, welche der Kapazitäten 11-14 gemessen werden sollen. Die Stoppbedingung TB wird insbesondere anhand der Anzahl der gezählten Perioden 38 des Messpotenzials UC oder anhand der gezählten Takte 39 des Taktsignals OSC bestimmt.

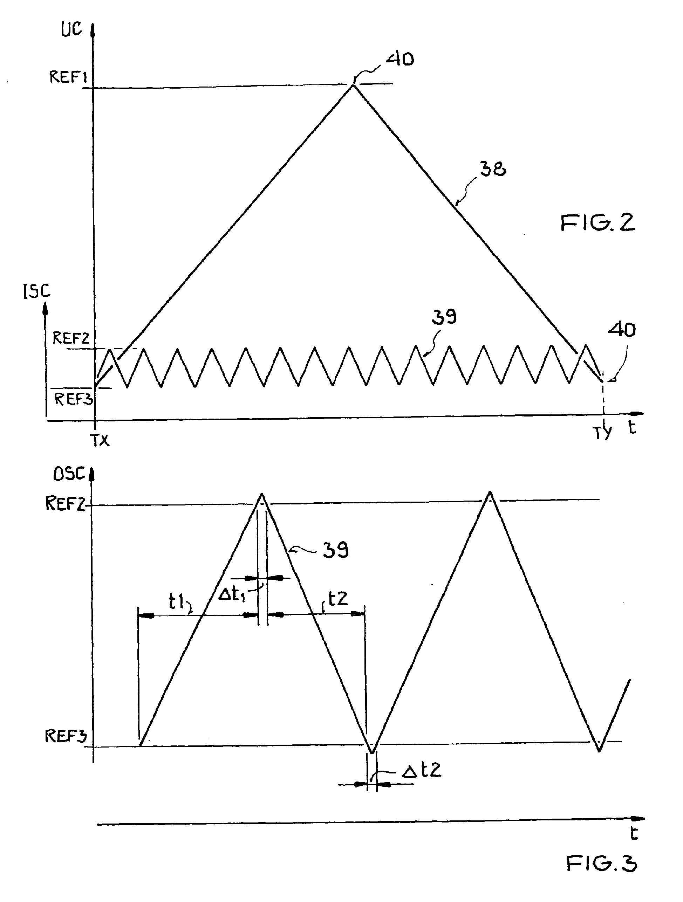

Nachfolgend wird das erfindungsgemäße Messverfahren zur Ermittlung der Kapazität CP des kapazitiven Drucksensors 11 anhand der Figuren 2 - 4 beschrieben.

Fig. 2 zeigt ein Signal-Zeit-Diagramm im Bereich einer einzelnen Periode des Messpotenzials UC zur Veranschaulichung der Funktionsweise des Periodenzählers 33 und des Messzählers 35. Der Beginn der Periode 38 ist hier mit TX und das Ende mit TY bezeichnet. Innerhalb dieser Zeitdauer T1 = TY - TX sind insgesamt 15 Takte 39 des Taktsignals OSC vorgesehen. Der Messzähler 35 misst diese Takte, wohingegen die Perioden 38 durch den Periodenzähler 33 gezählt werden. Im Idealfall weist das Messpotenzial UC ein Amplitudenmaximum REF1 und ein Amplitudenminimum REF3 auf, die jeweils dem oberen und unteren Schwellenwert UH bzw. UL entsprechen. Das Taktsignal OSC weist ein Amplitudenmaximum REF2 und das Amplitudenminimum REF3 auf. Das Amplitudenmaximum REF2 ist hier signifikant geringer als das Amplitudenmaximum REF1.

Beim Zweirampenmessverfahren wird lediglich ein einzelnes Laden und Entladen durchgeführt. Dies ist anhand der Messkurve für die Periode 38 dargestellt. Dabei kann es aber zu Ungenauigkeiten aufgrund eines unkorrelierten Rauschens im Bereich 40 der oberen und unteren Referenzschwellen REF1, REF3 kommen. Dieses unkorrelierte Rauschen führt typischerweise zu einer Reduzierung der Genauigkeit dieses Zweirampenmessverfahrens, wie bereits in der Beschreibungseinleitung ausführlich dargelegt wurde. Bei dem erfindungsgemäßen Messverfahren werden nun die einzelnen Takte 39 des Taktsignals OSC, die innerhalb der einfachen Periode 38 des Messsignals UC vorhanden sind, gemessen. Zwar existiert auch hier ein unkorreliertes Rauschen der jeweiligen Referenzschwellen REF2, REF3. Jedoch wird hier ein mehrfaches Durchlaufen eines Rampenverfahrens und insbesondere eines Zweirampenverfahrens durchgeführt. Mittels dieses mehrfachen Durchlaufens des Zweirampenverfahrens wird das unkorrelierte Rauschen der jeweiligen Referenzschwellen REF2, REF3 herausgemittelt. Der Vorteil besteht hier insbesondere auch darin, dass durch dieses Messverfahren eine geringere Versorgungsspannung einsetzbar ist, da für die vergleichsweise geringen Rampen im Falle des Taktsignals OSC gegenüber dem Messsignal UC eine signifikant geringere Versorgungsspannung VDD-GND benötigt wird.

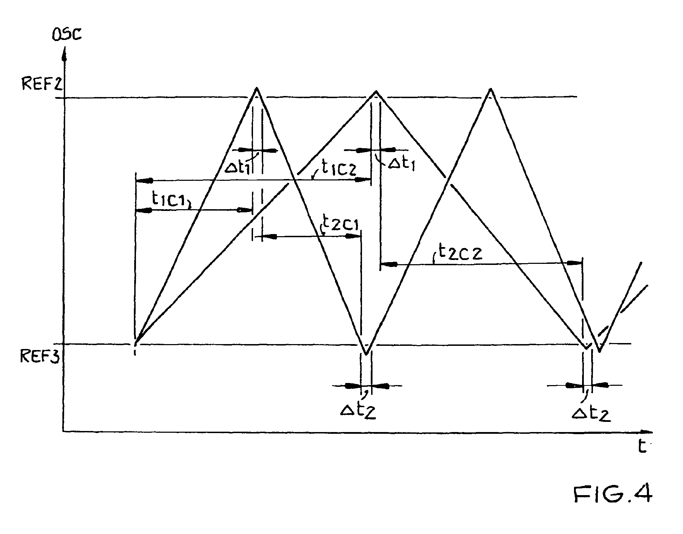

Die Fig. 3 und 4 zeigen zwei Signal-Zeit-Diagramme zur Veranschaulichung eines Umschaltfehlers $\Delta t_1$ und $\Delta t_2$ für die Referenzschwellen REF2, REF3, die bei dem Zweirampenverfahren entstehen können. Um diese Umschalt-fehler $\Delta t_1$ und $\Delta t_2$ möglichst genau bestimmen zu können, werden zwei Korrekturmessungen anhand der Korrekturkapazitäten 13, 14 durchgeführt. Auf diese Weise kann ein Umschaltfehler bei der Kapazitätsmessung zur Bestimmung der Sensorkapazität CP des Drucksensors 11 kompensiert werden. Auch werden die Umschaltfehler durch das mehrfache Durchführen des Zweirampenverfahrens für mehrere Perioden 38 bzw. mehrere Takte des Taktsignals OSC nicht aufaddiert.

Anhand dieser Fig. 3 und 4 soll nachfolgend das erfindungsgemäße Verfahren erläutert werden soll.

Beim Laden und Entladen mit einer Stromquelle lässt sich der zeitliche Verlauf einer Spannung U(t) an einer beliebigen Kapazität in Abhängigkeit von dem Strom I und der Zeit t wie folgt berechnen:

$$U(t) = 1/C * I * t$$

Zunächst wird nur eine Periode (siehe Fig. 4) betrachtet. Bei zwei Korrekturkapazitäten $C_2$, $C_1$, von denen die eine doppelt so groß ist, wie die andere, also für den Zusammenhang

$$C_2 = 2*C_1 \, ,$$

ergibt sich, da sich die Messdauer nur durch die zu messende Kapazität vergrößert, die Umschaltfehler jedoch unabhängig von der zu messenden Kapazität nur einfach eingehen, theoretisch der folgende Zusammenhang:

$$t_{C2} = 2*t_{C1}$$

$$t_{1C2} = 2*t_{1C1}$$

$$t_{2C2} = 2*t_{2C1},$$

Die tatsächliche Messdauer pro Periode ergibt sich aus:

$$t_{C1} = t_{1C1} + \Delta t_1 + t_{2C1} + \Delta t_2$$

$$t_{C2} = t_{1C2} + \Delta t_1 + t_{2C2} + \Delta t_2$$

Aufgrund der doppelten Laufzeit der Kapazität C1 gegenüber der Laufzeit der Kapazität C2 werden dabei zwei Perioden zurückgelegt, wodurch im Vergleich zur Kapazität C2 der Umschaltfehler bei der zweiten Periode der Kapazität C1 abgezogen werden muss. Da sich eine Kapazität proportional zur Zeit verhält (siehe oben), gilt

$$t_{C2} = 2*t_{C1} - \Delta t_1 - \Delta t_2$$

$$t_{1C2} + \Delta t_1 + t_{2C2} + \Delta t_2 = 2 \cdot t_{1C1} + \Delta t_1 + 2 \cdot t_{2C1} + \Delta t_2$$

Somit lassen sich die Umschaltfehler $\Delta t_1$ und $\Delta t_2$ auf beiden Seiten der Gleichungen subtrahieren und es ergibt sich folgender Zusammenhang:

$$t_{1C2} + t_{2C2} = 2 \cdot t_{1C1} + 2 \cdot t_{2C1}$$

Es bleibt die reine kapazitätsabhängige Messdauer:

$$t_{1C2} + t_{2C2} = 2 \cdot (t_{1C1} + t_{2C1})$$

Für die eigentlich Druck- und Temperaturmessungen werden nun die folgenden sechs Messungen durchgeführt, die in der nachfolgenden Tabelle 1 kurz aufgeführt sind.

Tabelle 1

|  | Bezeichnung | Stoppbedingung | Periodenanzahl (Periodenzähler) | Zählerstand (Messzähler) |
|---|---|---|---|---|
| 1. Messwert | Korrekturmessung (COR0) | Perioden = 128 | COR0_PER | COR0_CNT |
| 2. Messwert | Korrekturmessung 1 (COR1) | Perioden = 64 | COR1_PER | COR1_CNT |
| 3. Messwert | Druckmessung (P_REF) Referenzkapazität | Takte > 2048 | P_REF_PER | P_REF_CNT |
| 4. Messwert | Druckmessung (P_MEAS) Drucksensor | Takte > 1024 | P_MEAS_REF | P_MEAS_CNT |
| 5. Messwert | Temp.messung (T_REF) Referenzkapazität | Takte > 2048 | T_REF_PER | T_REF_CNT |
| 6. Messwert | Temp.messung (T_MEAS) Drucksensor | Takte > 1024 | T_MEAS_PER | T_MEAS_CNT |

Die erste Spalte gibt dabei die aufeinanderfolgenden sechs Messschritte zur Druck- und Temperaturmessung an. Die zweite Spalte gibt an, welche Messgröße gemessen werden soll, wobei mit COR0, COR1 der jeweilige Korrekturkapazität gemessen werden soll. Mit P_REF und P_MEAS sollen der jeweilige Referenzdruck und Messdruck mittels der Referenzkapazität 12 bzw. des Drucksensors (Messsensors) 11 ermittelt werden. Mit T_REF und T_MEAS sollen die jeweilige Referenztemperatur und Messtemperatur ermittelt werden. Die dritte Spalte gibt die jeweils erforderliche Periodenanzahl bzw. Taktzahl und somit die Stoppbedingung an, die durch den Periodenzähler 33 bzw. den Messzähler 35 gezählt werden und bei denen eine jeweilige Messung als beendet gilt. Die vierte Spalte gibt das jeweilige Messergebnis bezogen auf die durch den Periodenzähler 33 gemessene Periodenanzahl und die fünfte Spalte gibt den entsprechenden Zählerstand des entsprechenden Zählers 35 an. Die mit "PER" bezeichneten Messgrößen sollen signalisieren, dass hier die entsprechende Periodenanzahl gemessen wurde. Die mit "CNT" angegebenen Größen geben an, dass das Ergebnis der jeweilige Zählerstand ist.

Für die Messungen wurden folgende Normierungen vorgenommen:

$$COR\_NOM = \frac{COR0\_CNT - COR1\_CNT}{COR0\_PER - COR1\_PER}$$

$$P\_REF\_NOM = \frac{P\_REF\_CNT}{P\_REF\_PER}$$

$$P\_MEAS\_NOM = \frac{P\_MEAS\_CNT}{P\_MEAS\_PER}$$

$$T\_REF\_NOM = \frac{T\_REF\_CNT}{T\_REF\_PER}$$

$$T\_MEAS\_NOM = \frac{T\_MEAS\_CNT}{T\_MEAS\_PER}$$

Für die Messungen wurden ferner die folgenden Korrekturen berechnet:

$$P\_REF\_COR = P\_REF\_NOM - COR\_NOM$$

$$P\_MEAS\_COR = P\_MEAS\_NOM - COR\_NOM$$

$$T\_REF\text{-}COR = T\_REF\_NOM - COR\_NOM$$

$$T\_MEAS\_COR = T\_MEAS\_NOM - COR\_NOM$$

Mit den anhand der obigen Tabelle 1 gemessenen Werten sowie der entsprechenden Normierungen und Korrekturen lässt sich dann die Kapazität CP und die Temperatur TP des kapazitiven Drucksensors 11 wie folgt berechnen.

$$CP = C_0 * \frac{P\_MEAS\_COR}{P\_REF\_COR} * C_{gradient} + C_{offset}$$

$$TP = T_0 * \frac{T\_MEAS\_COR}{T\_REF\_COR} * T_{gradient} + T_{offset}$$

Die Konstanten werden zum Beispiel bestimmt mit 9 Messungsdurchläufen. Die Sensorkapazität CP soll zwischen 5 und 20 pF betragen und bei 233 und 398 Kelvin gemessen werden. Die Grundeinstellung für die Ermittlung der obigen Konstanten lautet wie folgt:

$$C_0 = 1; \; C_{gradient} = 1; \; C_{offset} = 0$$

$$T_0 = 1; \; T_{gradient} = 1; \; T_{offset} = 0$$

Die Konstanten $C_0$, $C_{gradient}$, $C_{offset}$ der obigen Gleichungen lassen sich für die Kapazitätsmessung wie folgt berechnen:

$$C_0 = \text{Mittelwert aus} \left( \frac{20\,pF}{\text{Mittelwert } \frac{P\_MEAS\_COR}{P\_REF\_COR} \text{ von 20 pF Messungen}} \right.$$

$$\frac{8\,pF}{\text{Mittelwert } \frac{P\_MEAS\_COR}{P\_REF\_COR} \text{ von 8 pF Messungen}} ; \frac{5\,pF}{\text{Mittelwert } \frac{P\_MEAS\_COR}{P\_REF\_COR} \text{ von 5 pF Messungen}} \left. \right)$$

$$C_{gradient} = \frac{\frac{20\,pF}{C_0} / \left[ \text{Mittelwert } \frac{P\_MEAS\_COR}{P\_REF\_COR} \text{ von 20 pF Messungen} \right]}{\frac{5\,pF}{C_0} / \left[ \text{Mittelwert } \frac{P\_MEAS\_COR}{P\_REF\_COR} \text{ von 5 pF Messungen} \right]}$$

$$C_{offset} = \text{Mittelwert aus}$$

$$(20\,pF - \left[ \text{Mittelwert} \left( C_0 * \frac{P\_MEAS\_COR}{P\_REF\_COR} * C_{gradient} \right) \text{ von 20 pF Messungen} \right] +$$

$$8\,pF - \left[ \text{Mittelwert} \left( C_0 * \frac{P\_MEAS\_COR}{P\_REF\_COR} * C_{gradient} \right) \text{ von 8 pF Messungen} \right] +$$

$$5\,pF - \left[ \text{Mittelwert} \left( C_0 * \frac{P\_MEAS\_COR}{P\_REF\_COR} * C_{gradient} \right) \text{ von 5 pF Messungen} \right] )$$

Ferner lassen sich auch die Konstanten $T_0$, $T_{gradient}$, $T_{offset}$ der obigen Gleichungen für die Temperaturmessung wie folgt berechnen:

$$T_0 = \text{Mittelwert aus} \left( \dfrac{398\,\text{K}}{\text{Mittelwert } \dfrac{T\_MEAS\_COR}{T\_REF\_COR} \text{ von 398 K Messungen}} \right.$$

$$\dfrac{300\,\text{K}}{\text{Mittelwert } \dfrac{T\_MEAS\_COR}{T\_REF\_COR} \text{ von 300 K Messungen}} \; ; \; \dfrac{233\,\text{K}}{\text{Mittelwert } \dfrac{T\_MEAS\_COR}{T\_REF\_COR} \text{ von 233 K Messungen}}$$

$$T_{gradient} = \dfrac{\dfrac{398\,\text{K}}{T_0} \Big/ \left[ \text{Mittelwert } \dfrac{T\_MEAS\_COR}{T\_REF\_COR} \text{ von 398 K Messungen} \right]}{\dfrac{233\,\text{K}}{T_0} \Big/ \left[ \text{Mittelwert } \dfrac{T\_MEAS\_COR}{T\_REF\_COR} \text{ von 233 K Messungen} \right]}$$

$T_{offset}$ **= Mittelwert aus**

$$(398\,\text{K} - \left[ \text{Mittelwert} \left( T_0 * \dfrac{T\_MEAS\_COR}{T\_REF\_COR} * T_{gradient} \right) \text{von 398 K Messungen} \right] +$$

$$300\,\text{K} - \left[ \text{Mittelwert} \left( T_0 * \dfrac{T\_MEAS\_COR}{T\_REF\_COR} * T_{gradient} \right) \text{von 300 K Messungen} \right] +$$

$$233\,\text{K} - \left[ \text{Mittelwert} \left( T_0 * \dfrac{T\_MEAS\_COR}{T\_REF\_COR} * T_{gradient} \right) \text{von 233 K Messungen} \right] )$$

Obgleich die vorliegende Erfindung vorstehend anhand eines konkreten und bevorzugten Ausführungsbeispiels näher beschrieben wurde, sei sie nicht darauf beschränkt, sondern lässt sich im Rahmen der Erfindung beliebig verändern und modifizieren. Insbesondere versteht es sich von selbst, dass die gewählten Zahlenangaben lediglich beispielhaft zu verstehen sind, jedoch die Erfindung nicht dahingehend beschränken sollen. Gleiches gilt für die gewählten Schaltungselemente und Schaltungsteile, die der besseren Übersichtlichkeit halber möglichst einfach dargestellt wurden. Es versteht sich von selbst, dass die erfindungsgemäße Messeinrichtung beliebig erweitert und modifiziert werden kann.
Auch ist die Erfindung selbstverständlich nicht ausschließlich für ein Reifendruckkontrollsystem und auch nicht notwendigerweise für eine Bestimmung reifenspezifischer Parameter ausschließlich geeignet. Vielmehr lässt sich die Erfindung auch bei anderen Messeinrichtungen und für andere Wandlerverfahren vorteilhaft einsetzen.

Bezugszeichenliste

| 10 | Messeinrichtung |
| 11 | kapazitiver Drucksensor |
| 12 | Referenzkapazität |
| 13, 14 | Korrekturkapazitäten |
| 15 | steuerbare Schalter |

| 16 | Messknoten |
|---|---|
| 17, 18 | Versorgungsanschlüsse |
| 19 | Kapazitätsanordnung |
| 20, 21 | Stromquellen |
| 22 | Abgriff, Ausgang |
| 23, 24 | steuerbare Schalter |
| 25 | Stromquellenanordnung |
| 30 | Schwellwertschaltung |
| 31 | Rückkopplungspfad |
| 32 | Inverter |
| 33 | Periodenzähler |
| 34 | Oszillator |
| 35 | Messzähler |
| 36,37 | Ausgänge |
| 38 | Perioden, Periodensignal |
| 39 | Takte, Taktsignal |
| 40 | Bereich |

| CORO, COR1 | Korrekturkapazitäten |
|---|---|
| CP | Messkapazität |
| CREF | Referenzkapazität |
| GND | zweites, negatives Versorgungspotenzial |
| IE | Entladestrom |
| IL | Ladestrom |
| OSC | Taktsignal |
| REF1 - REF3 | Referenzschwellen |
| T | Zeitdauer |
| T1 | Zeitdauer einer einzelnen Periode |
| TA | Startzeit |
| TB | Stoppzeit |
| TX, TY | Zeiten |
| UC, UC' | Messpotenzial |
| UH, UL | Schwellen des Messpotenzials |
| VDD | erstes, positives Versorgungspotenzial |
| XCNT | Zählerstandsignal des Messzählers |
| XPER | Zählerstandsignal des Periodenzählers |

**Patentansprüche**

1. Messeinrichtung (10) zur kapazitiven Druck- und/oder Temperaturmessung, insbesondere für Reifendruckkontrollsysteme,
   mit zumindest einem Sensor (11), der ein kapazitives Messelement (11) zum Erfassen einer Zustandsgröße, welche an einem ausgangsseitigen Messknoten (16) des Messelements (11) anliegt, aufweist,
   mit einer Lade-/Entladeschaltung (30, 25) zum wechselseitigen Aufladen und Entladen des Messelements (11) und zur Erzeugung eines sägezahnartigen Messpotenzials (UC) an dem Messknoten (16) als Maß für die Kapazität des Messelements (11),
   mit zumindest einem nach dem Zweirampenverfahren arbeitenden A/D-Wandler, mit einem Periodenzähler (33), der die Perioden (38) des Messpotenzials (UC) ermittelt, und mit einem Taktzähler (35), der die Takte (39) eines Taktsignals (OSC) ermittelt, die innerhalb der Dauer (T1) zumindest einer Periode (38) des Messpotenzials (UC) liegen, wobei die Messeinrichtung über mehrere Perioden (38) aus der Anzahl der ermittelten Perioden (38) und Takte (39) eine Druck- und/oder Temperaturmessung durchführt.

2. Messeinrichtung nach Anspruch 1,
   **dadurch gekennzeichnet,**
   **dass** ein Oszillator (34) vorgesehen ist, der ausgangsseitig ein Oszillatortaktsignal (OSC) erzeugt, dessen Frequenz zumindest höher ist als die Frequenz des Messpotenzials (UC).

3. Messeinrichtung nach wenigstens einem der vorstehenden Ansprüche,
**dadurch gekennzeichnet,**
**dass** der Periodenzähler (33) ausgangsseitig ein erstes Zählerstandssignal (XPER) als Maß für die gezählten Perioden (38) des Messpotenzials (UC) ausgibt und dass der Taktzähler (35) ausgangsseitig ein zweites Zählerstandssignal (XCNT) als Maß für die gezählten Takte (39) des Taktsignals (OSC) ausgibt.

4. Messeinrichtung nach wenigstens einem der vorstehenden Ansprüche,
**dadurch gekennzeichnet,**
**dass** der Periodenzähler (33) und/oder der Taktzähler (35) als Aufwärtszähler oder als Abwärtszähler ausgebildet ist/sind, die ihren Zählerstand mit jeder Periode (38) des Messpotenzials (UC) bzw. mit jedem Takt (39) des Taktsignals (OSC) um plus eins inkrementieren bzw. dekrementieren.

5. Messeinrichtung nach wenigstens einem der vorstehenden Ansprüche,
**dadurch gekennzeichnet,**
**dass** die Lade-/Entladeschaltung (30, 25) zur Erzeugung des sägezahnartigen Messpotenzials (UC) zumindest eine schaltbare Stromquelle (20, 21) aufweist.

6. Messeinrichtung nach wenigstens einem der vorstehenden Ansprüche,
**dadurch gekennzeichnet,**
**dass** die Lade-/Entladeschaltung (30, 25) jeweils zumindest eine erste Stromquelle (20) zum Aufladen eines jeweils zu messenden kapazitiven Elements (11-14) und jeweils zumindest eine zweite Stromquelle (21) zum Entladen des jeweils zu messenden kapazitiven Elements (11-14) aufweist, wobei zum wechselseitigen Aufladen und Entladen zwischen jeder Stromquelle (20, 21) und dem Messknoten (16) zumindest ein steuerbarer Schalter (23, 24) angeordnet ist.

7. Messeinrichtung nach Anspruch 6,
**dadurch gekennzeichnet,**
**dass** die steuerbarer Schalter (23, 24) durch ein vom Messpotenzial (UC) abgeleitetes Steuersignal (UC') derart angesteuert sind, dass entweder die erste oder die zweite Stromquelle (20, 21) aktiviert ist.

8. Messeinrichtung nach wenigstens einem der vorstehenden Ansprüche,
**dadurch gekennzeichnet,**
**dass** die Lade-/Entladeschaltung (30, 25) zur Erzeugung des sägezahnartigen Verlaufs des Messpotenzials (UC) eine Schwellwertschaltung (34) aufweist, welche dem Messknoten (16) nachgeschaltet ist, die das Messpotenzial (UC) mit einem vorgegebenen oberen und unteren Schwellenwert (UH, UL) vergleicht und die bei Überschreiten des Messpotenzials (UC) über den oberen Schwellenwert (UH) bzw. bei Unterschreiten des Messpotenzials (UC) unter den unteren Schwellenwert (UL) das Steuersignal (UC') zur Ansteuerung der steuerbaren Schaltern (23, 24) derart ändert, dass der Lade-/Entladevorgang des zu messenden Elements (11) dadurch umgekehrt ist.

9. Messeinrichtung nach wenigstens einem der vorstehenden Ansprüche,
**dadurch gekennzeichnet,**
**dass** der Sensor (11) eine Kapazitätsanordnung (19) aufweist, die neben dem Messelement (11) zur Erfassung der Zustandsgröße zumindest ein kapazitives Referenzelement (12) als Referenz für das Messelement (11) aufweist.

10. Messeinrichtung nach wenigstens einem der vorstehenden Ansprüche,
**dadurch gekennzeichnet,**
**dass** die Kapazitätsanordnung (19) zumindest zwei Korrekturkapazitäten (13, 14) aufweist, welche für ein Herausmitteln eines unkorrelierten Rauschens, welches durch ein Über- oder Unterschreiten des Messpotenzials (UC) über eine obere Referenzschwelle (REF1, REF2) bzw. unter eine untere Referenzschwelle (REF3) entsteht, vorgesehen sind.

11. Messeinrichtung nach Anspruch 10,
**dadurch gekennzeichnet,**
**dass** eine erste Korrekturkapazität (14) gegenüber der zweiten Korrekturkapazität (13) einen doppelten Kapazitätswert aufweist.

12. Messeinrichtung nach wenigstens einem der vorstehenden Ansprüche,
**dadurch gekennzeichnet,**

**dass** die Zustandsgröße ein Reifen spezifischer Parameter, insbesondere der Reifendruck oder die Reifentemperatur, ist.

13. Messeinrichtung nach wenigstens einem der vorstehenden Ansprüche,
**dadurch gekennzeichnet,**
**dass** der Sensor (11) als kapazitiver Drucksensor zum Erfassen eines Drucks ausgebildet ist.

14. Zweirampenmessverfahren zur kapazitiven Druckmessung mittels einer Messeinrichtung (10) nach wenigstens einem der vorstehenden Ansprüche, insbesondere für Reifendruckkontrollsysteme,
bei dem eine Messung eines Messpotenzials (UC) eines zu messenden kapazitiven Elementes (11-14) mehrfach wiederholt wird, um ein unkorreliertes Rauschen, welches durch ein Über- oder Unterschreiten des Messpotenzials (UC) über die obere Referenzschwelle (REF1, REF2) bzw. unter die untere Referenzschwelle (REF3) entsteht, herauszumitteln.

15. Verfahren nach Anspruch 14,
**dadurch gekennzeichnet,**
**dass** zur Messung des Messpotenzials (UC) ein Taktsignal (OSC) verwendet wird, dessen Frequenz zumindest höher ist als die Frequenz des Messpotenzials (UC).

16. Verfahren nach Anspruch 15,
**dadurch gekennzeichnet,**
**dass** sowohl die Takte (39) des Taktsignals (OSC), als auch die Perioden (38) des Messpotenzials (UC) gezählt werden.

**Claims**

1. Measuring equipment (10) for capacitive pressure and/or temperature measurement, particularly for tyre pressure control systems, with at least one sensor (1), which comprises a capacitive measuring element (11) for detection of a state magnitude, which bears on an output measuring junction (16) of the measuring element (11), with a charging/discharging circuit (30, 25) for alternate charging and discharging of the measuring element (11) and for producing a sawtooth-like measurement potential (UC) at the measurement junction (16) as a measure of the capacitance of the measuring element (11), with at least one analog-to-digital converter which operates according to the double-ramp method, with a period counter (33), which ascertains the periods (38) of the measurement potential (UC), and with a cycle counter (35), which ascertains the cycles (39) of a clock signal (OSC) lying within the duration (T1) of at least one period (38) of the measurement potential (UC), wherein the measuring equipment carries out a pressure and/or temperature measurement over several periods (38) from the number of ascertained periods (38) and cycles (39).

2. Measuring equipment according to claim 1, **characterised in that** an oscillator (34) is provided, which produces at the output an oscillator clock signal (OSC), the frequency of which is at least higher than the frequency of the measurement potential (UC).

3. Measuring equipment according to at least one of the preceding claims, **characterised in that** the period counter (33) issues at the output a first counter state signal (XPER) as a measure for the counted periods (38) of the measurement potential (UC) and that the cycle counter (35) issues at the output a second counter state signal (XCNT) as a measure for the counted cycles (38) of the clock signal (OSC).

4. Measuring equipment according to at least one of the preceding claims, **characterised in that** the period counter (33) and/or the cycle counter (35) is or are constructed as an upward counter or as a downward counter, which increment or decrement the counter state thereof by plus one with each period (38) of the measurement potential (UC) or with each cycle (39) of the clock signal (OSC).

5. Measuring equipment according to at least one of the preceding claims, **characterised in that** the charging/discharging circuit (30, 25) for generating the sawtooth-like measurement potential (UC) comprises at least one switchable current source (20, 21).

6. Measuring equipment according to at least one of the preceding claims, **characterised in that** the charging/discharging circuit (30, 25) comprises at least one first current source (20) for charging a respective capacitive element (11-14), which is to be measured, and at least one respective second current source (21) for discharging the respective capacitive element (11-14), which is to be measured, wherein at least one controllable switch (23, 24) is arranged between each current source (20, 21) and the measurement junction (16) for the alternate charging and discharging.

7. Measuring equipment according to claim 6, **characterised in that** the controllable switches (23, 24) are controlled in drive by a control signal (UC'), which is derived from the measurement potential (UC), in such a manner that either the first or the second current source (20, 21) is activated.

8. Measuring equipment according to at least one of the preceding claims, **characterised in that** the charging/discharging circuit (30, 25) for generating the sawtooth-like course of the measurement potential (UC) comprises a threshold value circuit (34) which is connected downstream of the measurement junction (16), compares the measurement potential (UC) with a predetermined upper and lower threshold value (UH, UL) and in the case of exceeding the measurement potential (UC) by the upper threshold value (UH) or falling below the measurement potential (UC) by the lower threshold value (UL) changes the control signal (UC') for drive control of the controllable switches (23, 24) in such a manner that the charging/discharging process of the element (11) to be measured is thereby reversed.

9. Measuring equipment according to at least one of the preceding claims, **characterised in that** the sensor (11) comprises a capacitance arrangement (19) which, apart from the measuring element (11) for detection of the state magnitude, comprises at least one capacitive reference element (12) as a reference for the measurement element (11).

10. Measuring equipment according to at least one of the preceding claims, **characterised in that** the capacitance arrangement (19) comprises at least two corrective capacitances (13, 14) provided for averaging out an uncorrelated noise arising due to an exceeding or falling below of the measurement potential (UC) above an upper reference threshold (REF1, REF2) or below a lower reference threshold (REF3), respectively.

11. Measuring equipment according to claim 10, **characterised in that** a first corrective capacitance (14) has twice the capacitance value by comparison with the second corrective capacitance (13).

12. Measuring equipment according to at least one of the preceding claims, **characterised in that** the state magnitude is a tyre-specific parameter, particularly the tyre pressure or the tyre temperature.

13. Measuring equipment according to at least one of the preceding claims, **characterised in that** the sensor (11) is constructed as a capacitive pressure sensor for detection of a pressure.

14. Double-ramp measuring method for capacitive pressure measurement by means of measuring equipment (10) according to at least one of the preceding claims, particularly for tyre pressure control systems, in which a measurement of a measurement potential (UC) of a capacitive element (11-14), which is to be measured, is repeated several times in order to average out an uncorrelated noise which arises due to an exceeding or falling below of the measurement potential (UC) above the upper reference threshold (REF1, REF2) or below the lower reference threshold (REF3), respectively.

15. Method according to claim 14, **characterised in that** for measurement of the measurement potential (UC) use is made of a clock signal (OSC), the frequency of which is at least higher than the frequency of the measurement potential (UC).

16. Method according to claim 15, **characterised in that** not only the cycles (39) of the clock signal (OSC), but also the periods (38) of the measurement potential (UC) are counted.

**Revendications**

1. Dispositif de mesure (10) destiné à réaliser une mesure de pression et/ou de température par effet capacitif, plus particulièrement pour des systèmes de contrôle de la pression des pneus, comportant :

. au moins un capteur (11) qui présente un élément capacitif de mesure (11) destiné à mesurer une grandeur d'état qui est en contact avec un noeud de mesure (16) côté sortie de l'élément de mesure (11),

. un circuit de charge/décharge (30, 25) pour charger et décharger l'élément de mesure (11) et vice-versa et pour générer une tension de mesure (UC) en dents de scie au noeud de mesure (16) comme mesure pour la capacité de l'élément de mesure (11),

. au moins un convertisseur analogique/numérique double rampe comprenant un compteur de périodes (33) qui calcule les périodes (38) de la tension de mesure (UC) et un compteur d'impulsions d'horloge (35) qui calcule les impulsions (39) d'un signal d'horloge (OSC) produites pendant la durée (T1) d'au moins une période (38) de la tension de mesure (UC), le dispositif de mesure effectuant une mesure de la pression et/ou de la température sur plusieurs périodes (38) à partir du nombre de périodes (38) et impulsions d'horloge (39) calculées.

2. Dispositif de mesure selon la revendication 1, **caractérisé en ce que** l'on prévoit un oscillateur (34) qui délivre côté sortie un signal d'horloge d'oscillateur (OSC), dont la fréquence est au moins supérieure à la fréquence de la tension de mesure (UC).

3. Dispositif de mesure selon l'une au moins des revendications précédentes, **caractérisé en ce que** le compteur de périodes (33) délivre côté sortie un premier signal d'état de compteur (XPER) comme mesure pour les périodes comptées (38) de la tension de mesure (UC) et **en ce que** le compteur d'impulsions d'horloge (35) délivre côté sortie un deuxième signal d'état de compteur (XCNT) comme mesure pour les impulsions d'horloge (39) comptées du signal d'horloge (OSC).

4. Dispositif de mesure selon l'une au moins des revendications précédentes, **caractérisé en ce que** le compteur de périodes (33) et/ou le compteur d'impulsions (35) est/sont conformé(s) sous la forme de compteur(s) ou décompteurs qui incrémentent ou décrémentent de plus un leur état de compteur pour chaque période (38) de la tension de mesure (UC) ou avec chaque impulsion d'horloge (39) du signal d'horloge (OSC).

5. Dispositif de mesure selon l'une au moins des revendications précédentes, **caractérisé en ce que** le circuit de charge/décharge (30, 25) présente au moins une source de courant (20, 21) pouvant être basculée pour produire la tension de mesure (UC) en dents de scie.

6. Dispositif de mesure selon l'une au moins des revendications précédentes, **caractérisé en ce que** le circuit de charge/décharge (30, 25) présente à chaque fois au moins une première source de courant (20) pour charger à chaque fois un élément capacitif à mesurer (11-14) et à chaque fois au moins une deuxième source de courant (21) pour décharger à chaque fois l'élément capacitif à mesurer (11-14), un interrupteur commandable (23, 24) au moins étant disposé entre chaque source de courant (20, 21) et le noeud de mesure (16) en vue du chargement et du déchargement et vice-versa.

7. Dispositif de mesure selon la revendication 6, **caractérisé en ce que** les interrupteurs commandables (23, 24) sont commandés par un signal de commande (UC') déduit de la tension de mesure (UC) de telle manière que soit la première soit la deuxième source de courant (20, 21) est activée.

8. Dispositif de mesure selon l'une au moins des revendications précédentes, **caractérisé en ce que** le circuit de charge/décharge (30, 25) présente en vue de la génération de la tension de mesure (UC) en dents de scie un circuit de valeur de seuil (34) monté en aval du noeud de mesure (16) qui compare la tension de mesure (UC) à une valeur de seuil prédéfinie supérieure et inférieure (UH, UL) et qui en cas de dépassement, par la tension de mesure (UC), de la valeur de seuil supérieure (UH) ou en cas de passage, par la tension de mesure (UC), en-dessous de la valeur de seuil inférieure (UL), modifie le signal de commande (UC') des interrupteurs commandables (23, 24) de telle façon que le processus de charge/décharge de l'élément à mesurer (11) en est inversé.

9. Dispositif de mesure selon l'une au moins des revendications précédentes, **caractérisé en ce que** le capteur (11) présente un dispositif capacitif (19) qui, en plus de l'élément de mesure (11) pour mesurer la grandeur d'état, présente au moins un élément de référence capacitif (12) comme référence pour l'élément de mesure (11).

10. Dispositif de mesure selon l'une au moins des revendications précédentes, **caractérisé en ce que** le dispositif capacitif (19) présente au moins deux capacités de correction (13, 14) prévues pour détecter un bruit non corrélé généré lorsque la tension de mesure (UC) dépasse un seuil de référence supérieur (REF1, REF2) ou passe en-dessous d'un seuil de référence inférieur (REF3).

**11.** Dispositif de mesure selon la revendication 10, **caractérisé en ce qu'**une première capacité de correction (14) présente une valeur capacitive double par rapport à la deuxième capacité de correction (13).

**12.** Dispositif de mesure selon l'une au moins des revendications précédentes, **caractérisé en ce que** la grandeur d'état est un paramètre spécifique d'un pneu, plus particulièrement la pression ou la température d'un pneu.

**13.** Dispositif de mesure selon l'une au moins des revendications précédentes, **caractérisé en ce que** le capteur (11) est un capteur de pression capacitif pour mesurer une pression.

**14.** Procédé de mesure double rampe pour la mesure de pression capacitive à l'aide d'un dispositif de mesure (10) selon l'une au moins des revendications précédentes, plus particulièrement pour des système de contrôle de la pression de pneus, dans lequel on répète à plusieurs reprises la mesure d'une tension de mesure (UC)d'un élément capacitif (11-14) à mesurer, pour détecter un bruit non corrélé généré lorsque la tension de mesure (UC) dépasse le seuil de référence supérieur REF1, REF2) ou passe en-dessous du seuil de référence inférieur (REF3).

**15.** Procédé selon la revendication 14, **caractérisé en ce que** pour mesurer la tension de mesure (UC) on utilise un signal d'horloge (OSC) dont la fréquence est au moins supérieure à la fréquence de la tension de mesure (UC).

**16.** Procédé selon la revendication 15, **caractérisé en ce que** l'on compte aussi bien les impulsions (39) du signal d'horloge (OSC) que les périodes (38) de la tension de mesure (UC).

FIG. 1

FIG. 1A

UC

REF1

40

38

FIG. 2

ISC

REF2

39

40

REF3

TX

TY

t

OSC

REF2

39

$t1$

$\Delta t_1$

$t2$

REF3

$\Delta t2$

t

FIG. 3

FIG.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3761805 A

**In der Beschreibung aufgeführte Nicht-Patentliteratur**

- **KLAUS FINKENZELLER.** RFID-Handbuch. Hanser Verlag, 2002
- **WERNER SCHULZ.** Integrierter Drucksensor wird drahtlos versorgt. *Zeitschrift Elektronik,* Juli 2000, 54

- **TIETZE ; SCHENK.** *Halbleiterschaltungstechnik,* 1059-1060